# EUROPÄISCHE PATENTANMELDUNG

(11) **EP 0 975 071 A1**
(43) Veröffentlichungstag der Anmeldung: **26.01.2000**
(21) Anmeldenummer: 99105999.9
(22) Anmeldetag: 25.03.1999
(51) Int. Cl.: H01R 43/02, H01R 12/36

(54) **Bauelement für die SMD-Oberflächenmontage auf einem Trägerelement**

(30) Priorität: 14.07.1998 DE 29812524 U
(71) Anmelder: ROBERT BOSCH GMBH, 70442 Stuttgart (DE)
(72) Erfinder: Heller, Ingolf, 31135 Hildesheim (DE); Jelinek, Egbert, 31157 Sarstedt (DE)

(57) **Zusammenfassung**

Ein Bauelement (11) als eine Kontaktelementeleiste ist in SMD-Oberflächenmontage auf einem Trägerelement (28) aufzubringen.

Das Bauelement (11) weist eine Vielzahl von Kontaktelementen (13) auf, die über eine Teillänge in einem Kontaktträger (12) gelagert sind und endseitig je einen Anschlußabschnitt (19) freiliegend aufweisen. Teil des Anschlußabschnittes (19) ist ein Fixierabschnitt (22), der zwischen einer Montageseite (23) des Bauelements (11) und einer Oberseite (27) des Trägerelements (28) angeordnet und Teil der Aufstandsfläche des Bauelements (11) auf dem Trägerelement (28) ist.

Das Bauelement (11) wird in elektrischen Geräten, insbesondere bei der Automobilindustrie, eingesetzt.

## Beschreibung

### Stand der Technik

Die Erfindung geht aus von einem Bauelement für die SMD-Oberflächenmontage auf einem Trägerelement. Durch die DE 35 44 125 C2 ist ein gattungsgemäßes Bauelement bekannt.

Bei der SMD-Oberflächenmontage, wobei SMD für Surface Mounted Device steht, werden auf Trägerelementen, insbesondere Leiterplatten, Bauelemente ein- oder zweiseitig aufgesetzt und direkt an der Oberfläche der Leiterplatten befestigt. Die Bauelemente werden dazu auf den Leiterplatten zunächst provisorisch vorfixiert, beispielsweise über einen Klebstoff. Während die üblicherweise sehr kleinen elektronischen Bauelemente beim Aufbringen keine Schwierigkeiten aufwerfen, gibt es bei größeren Bauelementen mitunter mechanische Probleme, so daß die erforderliche Vorjustierung der Bauelemente auf den Leiterplatten über von der SMD-Technik unabhängigen, also separaten Befestigungselementen, wie Winkel mit Schraubanschlüssen erfolgt.

Damit ist der Fertigungsvorteil der SMD-Montagetechnik, der auf vollautomatischer Bestückung und Fertigstellung der bestückten Leiterplatten durch spezielle Lötverfahren beruht, nicht mehr in vollem Umfang gegeben. Durch die Zuführung der Leiterplatten von einer vollautomatischen Fertigungsstraße zu einer Handbestückungsstation werden die Herstellkosten jedes des mit dem Bauelement zu bestückenden Trägerelements in unerwünschter Weise kostenintensiv.

### Vorteile der Erfindung

Das erfindungsgemäße Bauelement für die SMD-Oberflächenmontage auf einem Trägerelement mit den kennzeichnenden Merkmalen des Anspruchs 1 hat demgegenüber den Vorteil, daß die zuvor erwähnte Unzulänglichkeit in zufriedenstellendem Maß vermieden wird. Dazu ist das Bauelement so ausgebildet, daß es mit handelsüblichen Bestückungsmaschinen auf das Trägerelement in einer stabilen Lage aufgesetzt werden kann. Damit entfällt eine separate Fixierung oder eine provisorische Lagesicherung des Bauelements durch hilfsweise, vorübergehend angebrachte Stabilisierungsteile.
Damit kann das mit dem Bauelement bestückte Trägerelement in automatisierter Produktion kostengünstig gefertigt werden.

### Zeichnung

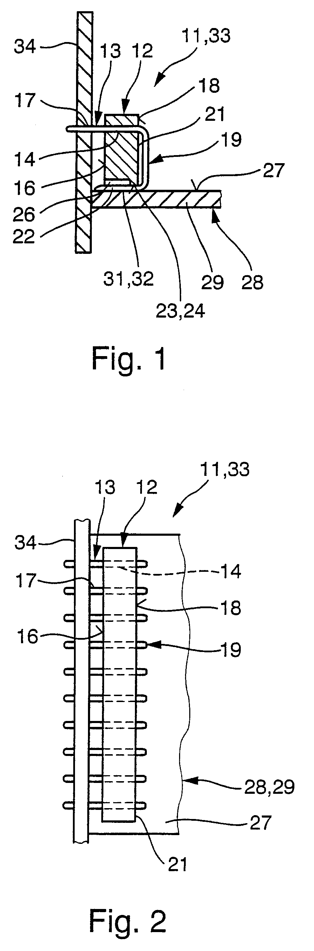

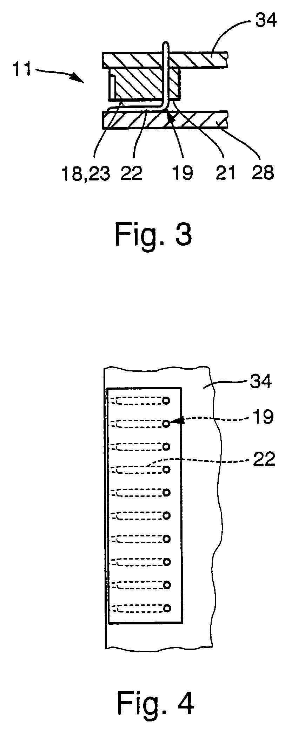

Zwei Ausführungsbeispiele der Erfindung sind in der Zeichnung schematisiert dargestellt und in der nachfolgenden Beschreibung näher erläutert. Es zeigen die Figuren 1 und 2 das erste und die Figuren 3 und 4 das zweite Ausführungsbeispiel, wobei die Figuren 1 und 3 als Schnittdarstellungen und die Figuren 2 und 4 als Seitenansichten eines mit dem Trägerelement rechtwinklig gekippten Bauelements ausgeführt sind.

### Beschreibung der Ausführungsbeispiele

Ein Bauelement 11 als eine Kontaktelementeleiste nach den Figuren 1 und 2 besteht im wesentlichen aus einem quaderförmigen Kontaktträger 12 aus elektrisch isolierendem Kunststoff und aus einer Vielzahl von Kontaktelementen 13, die über eine Teillänge entlang eines Befestigungsabschnittes 14 in dem Kontaktträger 12 eingebettet und gehalten sind.

Die in einer Reihe, alternativ in mehreren Reihen angeordneten Kontaktelemente 13 ragen jeweils lotrecht endseitig aus dem Kontaktträger 12 heraus, zum einen, an einer Vorderseite 16 des Kontaktträgers 12, mit einem Kontaktabschnitt 17, der die Steckrichtung des Bauelements 11 aufzeigt und zum anderen, an einer zu der Vorderseite 16 parallel versetzten Rückseite 18 des Kontaktträgers 12, mit einem Anschlußabschnitt 19.

Der Anschlußabschnitt 19 verläuft, beginnend mit dem Austritt des Kontaktelements 13 aus der Rückseite 18, rechtwinklig abgebogen, parallel zu einer in der Figur 1 vertikal gerichteten, stirnseitigen Kante 21 des Kontaktträgers 12 entlang der Rückseite 18. An deren Ende ist der Anschlußabschnitt 19 erneut rechtwinklig abgebogen und verläuft danach, als Fixierabschnitt 22, parallel versetzt zu dem Befestigungsabschnitt 14, unterhalb einer Montageseite 23 des Bauelements 11, entsprechend einem Boden 24 des Kontaktträgers 12.

Der Boden 24 weist, jeweils im Bereich des Fixierabschnittes 22, eine Aussparung 26 auf, die es fertigungstechnisch ermöglicht, den Fixierabschnitt 22 eng an dem Boden 24 entlang zu führen und den Fixierabschnitt 22 durch Überbiegen zur Kompensation seiner Rückfederung exakt einen nach der Figur 1 horizontalen Verlauf, senkrecht zur Kante 21, zu geben, wobei alle Fixierabschnitte 22 zusammen die Aufstandsfläche für das Bauelement 11 bilden und das Bauelement 11 unterhalb eines Schwerpunktes sicher und stabil abstützen.

Die Abstützung des Bauelements 11 über die Fixierabschnitte 22 erfolgt auf einer Oberseite 27 eines Trägerelements 28 in Form einer Leiterplatte. Das Trägerelement 28 ist für die SMD-Oberflächenmontage ausgebildet. Dazu ist auf einem aus elektrischem Isolierstoff bestehenden Grundkörper 29 des Trägerelements 28 im Siebdruckverfahren im Bereich von flächigen Anschlüssen 31 dickschichtig Lot 32 in Pastenform festhaftend aufgetragen. Auf diese Anschlüsse 31 sind die Fixierabschnitte 21 aufgesetzt.

Das so bestückte Trägerelement 28 wird in einem mit einer Wärmequelle, beispielsweise einer Rotlichtlampe ausgerüsteten Reflow-Ofen einer das Lot 32 aufschmelzenden Wärmebehandlung unterzogen, so daß Lötverbindungen zwischen den Anschlüssen 31 und den Fixierabschnitten 22 der Kontaktelemente 13 entstehen.

Durch diese stoffschlüssige Verankerung der Fixierabschnitte 22 an den Anschlüssen 31 ist unter Bildung einer Baugruppe 33 das Bauelement 11 stabil auf dem Trägerelement 28 verankert.

Diese Baugruppe 33 kann dann als eine von mehreren Bestückungseinheiten einer zentralen Hauptplatte 34 zugeführt und mit ihr verbunden werden, indem in nicht näher dargestellter Weise die Kontaktabschnitte 17 des Bauelements 11 in zugeordneten Bohrungen der Hauptplatte 34 eingebracht und dort fixiert werden.

Nach dem ersten Ausführungsbeispiel entsprechend den Figuren 1, 2 ist das Trägerelement 28 senkrecht zur Hauptplatte 34 angeordnet, während nach dem zweiten Ausführungsbeispiel entsprechend den Figuren 3 und 4 das Trägerelement 28 parallel zur Hauptplatte 34 plaziert ist. Dadurch ist der Anschlußabschnitt 19 beim zweiten Ausführungsbeispiel nur mit einer einzigen rechtwinkligen Abbiegung versehen und der entlang der Rückseite 18 geführte Teil des Anschlußabschnittes 19 bildet schon den Fixierabschnitt 22.

Der jeweilige Fixierabschnitt 22 ist zur Rückseite 18, die hier zugleich die Montageseite 23 bildet, etwas abgesetzt, damit es fertigungstechnisch möglich ist, den Fixierabschnitt 22 exakt parallel zur Kante 21 horizontal auszurichten, damit das Bauelement 11 auch bei diesem Ausführungsbeispiel unterhalb seines Schwerpunktes sicher und stabil durch die Fixierabschnitte 22 abgestützt wird.

Somit ist bei beiden Ausführungsbeispielen das Bauelement 11 auf dem Trägerelement 28 in fertigungstechnisch vorteilhafter Weise aufgebracht, in der das Bauelement 11 durch Bestückungsmaschinen zuführbar und in automatisierter Produktion kostengünstig verarbeitet ist.

## Patentansprüche

1. Bauelement für die SMD-Oberflächenmontage auf einem Trägerelement, insbesondere auf einer Leiterplatte, welches Bauelement (11) mittels einer Montageseite (23) einer Oberseite (27) des Trägerelements (28) zugeordnet wird, mit einem Kontaktträger (12) des Bauelements (11), in dem vorzugsweise in Reihen angeordnete Kontaktelemente (13) über eine Teillänge eingebettet gelagert sind, die Kontaktelemente (13) freiliegend endseitig einerseits je einen zur Montageseite (23) parallel verlaufenden Kontaktabschnitt (17) und andererseits je einen Anschlußabschnitt (19) aufweisen, welcher Anschlußabschnitt (19) zumindest mittelbar im Bereich eines Fixierabschnittes (22) mit wenigstens einem auf der Oberseite (27) des Trägerelements (28) angebrachten Anschluß (31) verbindbar ist, dadurch gekennzeichnet, daß der Anschlußabschnitt (19) zumindest mit dem Fixierabschnitt (22) zwischen der Montageseite (23) des Bauelements (11) und der Oberseite (27) des Trägerelements (28) angeordnet ist.

2. Bauelement nach Anspruch 1, dadurch gekennzeichnet, daß das Bauelement (11) eine Kontaktelementeleiste ist und die Kontaktelemente (13) jeweils den Anschlußabschnitt (19) mit dem Fixierabschnitt (22) in einteiliger Form als biegesteifes Teil aufweisen.

3. Bauelement nach Anspruch 2, dadurch gekennzeichnet, daß der Fixierabschnitt (22) zur Montage des Bauelements (11) auf dem Trägerelement (28) horizontal gerichtet ist und wenigstens zwei Fixierabschnitte (22) die Aufstandsfläche für das Bauelement (11) unter dessen Schwerpunkt bilden.

4. Bauelement nach Anspruch 3, dadurch gekennzeichnet, daß der Kontaktträger (12) Aussparungen (26) zur exakten horizontalen Ausrichtung der Fixierabschnitte (22) aufweist.
